# FASCICULE DE BREVET EUROPEEN

(11) **EP 0 524 306 B1**
(45) Date de publication et mention de la délivrance du brevet: **23.09.1998**
(21) Numéro de dépôt: 92906706.4
(22) Date de dépôt: 11.02.1992
(51) Int. Cl.: H04L 5/06, H04L 27/34

(54) **PROCEDE DE CODAGE EN BINAIRE DES POINTS D'UNE CONSTELLATION UTILISEE DANS UNE MODULATION MULTIPORTEUSE DE TYPE OFDM**
Verfahren zur Binärkodierung von in einer OFDM-Typ Trägermodulation verwendeten Konstellationspunkten.
METHOD FOR THE BINARY CODING OF POINTS OF A CONSTELLATION USED IN A MULTICARRIER MODULATION OF THE OFDM TYPE

(30) Priorité: 12.02.1991 FR 9101584
(43) Date de publication de la demande: 27.01.1993
(73) Titulaire: THOMSON multimedia, 92648 Boulogne Cédex (FR)
(72) Inventeur: DE COUASNON, Tristant, F-92045 Paris-La Défense Cédex 67 (FR); MONNIER, Raoul, F-92045 Paris-La Défense Cédex 67 (FR); FOUCHE, Yvon, F-92045 Paris-La Défense Cédex 67 (FR); RAULT, Jean-Bernard, F-92045 Paris-La Défense Cédex 67 (FR)
(74) Mandataire: Ruellan-Lemonnier, Brigitte
(86) Numéro de dépôt international: FR9200117
(87) Numéro de publication internationale: WO9214316

(56) Documents cités:
- EP-A- 200 505
- EP-A- 365 431
- GB-A- 2 103 456
- US-A- 3 988 539
- US-A- 4 924 516

## Description

La présente invention concerne un procédé de transmission d'un signal numérique exploitant la modulation multiporteuse de type OFDM (pour Orthogonal Frequency Division Multiplexing en langue anglaise).

Dans la demande de brevet international WO-A-90 04893 déposée au nom de THOMSON-CSF, on a décrit un procédé d'émission particulièrement performant utilisant une modulation multiporteuse de type OFDM permettant d'émettre, avec une haute densité un signal numérisé. Dans le procédé d'émission décrit, on utilise une pluralité de fréquences orthogonales et on émet un couple (amplitude-phase) ou (partie réelle, partie imaginaire) sur chaque fréquence, le couple amplitude-phase ou partie réelle-partie imaginaire étant équivalent de façon bi-univoque à l'information à transmettre. Pour réaliser la fonction bi-univoque ci-dessus, on utilise de manière connue une constellation. En effet, chaque sous-porteuse constituant le signal est modulée en amplitude et en phase de façon discrète et les positions discrètes en amplitude et en phase constituent dans le plan complexe une constellation. Plusieurs types de constellation peuvent être utilisés. ainsi, dans la demande de brevet internationale PCT/FR89/00546 on a proposé une constellation circulaire. Dans ce cas, les couples amplitude-phase correspondant à chaque mot numérique se répartissent régulièrement sur des cercles concentriques. Le transcodage entre les mots binaires du signal numérisé et un point de la constellation peut être réalisé de multiples façons sans utiliser de relation particulièrement simple. Toutefois, il est important que ce codage permette d'éviter, lors de la réception, le maximum d'erreurs au niveau de la récupération du signal.

Il est connu, par exemple de la demande de brevet britannique publiée sous la référence 2.103.456, un codage par constellation dans laquelle deux points adjacents correspondent à des mots binaires qui diffèrent l'un de l'autre selon le code de Gray.

Dans le cas d'une modulation multiporteuse de type OFDM, si l'on utilise une seule constellation pour l'ensemble des canaux, lorsque toutes les porteuses sont d'amplitude maximum et en phase, l'émetteur doit alors passer une pointe de puissance très forte risquant de saturer cet émetteur et, ainsi de distordre le signal. Ce phénomène se produit si l'on ne prend aucune précaution pour éviter les suites longues de "0" ou de "1" à l'entrée du dispositif.

Il est connu du brevet américain référencé 4,924,516 un procédé d'embrouillage de données pour modem, par affectation aléatoire d'une amplitude et phase pour la modulation d'un signal de type QAM (Quadrature Amplitude Modulation en anglo-saxon), mais le but est de sécuriser les communications.

La présente invention a pour but de fournir un procédé d'affectation d'une constellation à un canal qui permet d'éviter les inconvénients ci-dessus, en particulier la sommation en phase des signaux.

En conséquence, la présente invention a pour objet un procédé de transmission d'un signal numérique constitué d'une succession de mots binaires comportant un codage par constellation affectant à chaque mot binaire une amplitude et une phase et une modulation multiporteuse de type OFDM (Orthogonal Frequency Division Multiplexing) par le signal numérique, chaque porteuse correspondant à un canal, caractérisé en ce que ladite modulation est réalisée en affectant à chaque canal une constellation parmi un nombre fini de constellations, cette affectation étant effectuée de manière aléatoire et réalisée une fois pour toutes.

Selon un mode de réalisation particulier applicable notamment lorsque les points de la constellation se répartissent sur de quadrilatères imbriqués, deux points de la constellation horizontalement et verticalement adjacents correspondent à des mots binaires qui diffèrent l'un de l'autre par un seul bit tandis que deux points de la constellation diagonalement adjacents correspondent à des mots binaires qui diffèrent l'un de l'autre par deux bits.

D'autres caractéristiques et avantages de la présente invention apparaîtront à la lecture de la description faite ci-après de différents modes de réalisation, cette description étant faite avec référence aux dessins ci-annexés dans lesquels :
- la figure 1 est un schéma synoptique simplifié d'un émetteur auquel peut s'appliquer la présente invention ;
- la figure 2 est un schéma synoptique plus détaillé d'une partie de l'émetteur de figure 1 ;
- les figures 3 à 6 sont des schémas représentant différents codages conformes à la présente invention, et

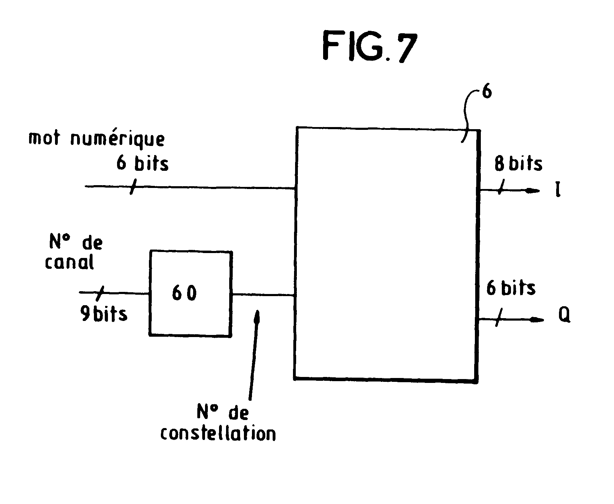

- la figure 7 est un schéma synoptique simplifié d'un élément de l'émetteur permettant l'affectation d'un canal selon la présente invention.

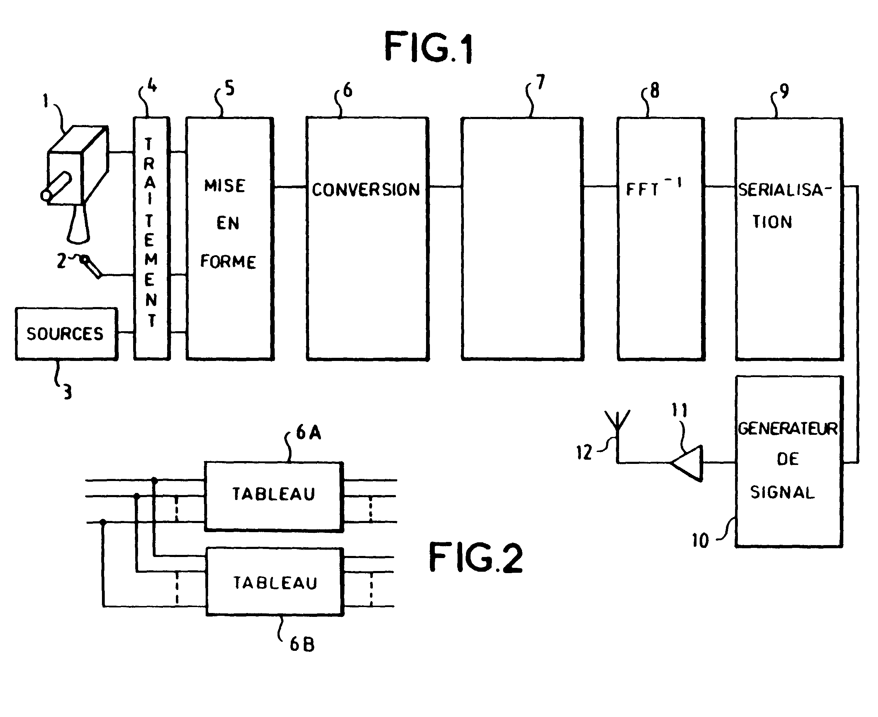

Sur la figure 1 on a représenté un schéma synoptique d'un émetteur utilisant des constellations codées selon le procédé de codage en binaire utilisé dans la présente invention. Cet émetteur permet l'émission d'ondes modulées selon le principe décrit dans la demande de brevet international WO-A-90 04893.

Dans l'exemple illustré sur la figure 1, le signal à émettre est fourni soit par une caméra de télévision 1, un microphone 2 et/ou d'autres sources 3. De manière avantageuse les sources 1, 2 et/ou 3 sont reliées à un dispositif de traitement d'informations 4 permettant d'effectuer un certain nombre de modifications telles qu'une réduction de débit d'informations, par exemple par élimination d'informations redondantes. D'autre part, le dispositif de traitement 4 peut comporter un dispositif d'embrouillage du signal de type connu . Le dispositif de traitement 4 est connecté à un circuit de mise en forme 5 qui effectue la mise sous la forme désirée des signaux issus des sources 1 à 3. Par exemple, le circuit de mise en forme 5 effectue le multiplexage des diverses sources et fournit en série des mots numériques. De manière connue, le circuit de mise en forme comporte des circuits d'échantillonage, des circuits convertisseurs analogiques-numériques et/ou des multiplexeurs. Les signaux numériques issus du circuit de mise en forme sont envoyés sur un circuit de conversion 6 qui réalise la conversion des signaux numériques en entrée en des signaux complexes. Ce circuit de conversion 6 comporte donc de manière connue une ou plusieurs constellations comme décrit dans la demande de brevet PCT/FR 89/00546.

Comme représenté sur la figure 2, le circuit de conversion 6 des mots numériques en signaux complexes peut comporter deux tableaux de conversion 6a, 6b formant une constellation stockée dans des circuits mémoires. On utilise par exemple pour le stockage des constellations, des mémoires permanentes de type mémoires mortes, mémoires programmables, mémoires mortes programmables effaçables, mémoires mortes programmables effaçables électriquement ou mémoires vives sauvegardées (ROM, PROM et EE.PROM ou RAM en terminologie anglo-saxonne). Les mots numériques à convertir correspondent aux adresses dans les tableaux, la valeur de l'amplitude ou la partie réelle du signal étant stockée à cette adresse dans un premier tableau 6a et la valeur de la phase ou la partie imaginaire du signal étant stockée dans le second tableau 6b par exemple. Les valeurs stockées dans les tableaux correspondent donc à une constellation dans le mode de réalisation représenté, cette constellation pouvant être codée de différentes manières, comme cela sera expliqué de manière plus détaillée ci-après. D'autre part, le circuit de conversion 6 est connecté à un dispositif de réarrangement 7 dont le rôle est de mettre les données à traiter dans un format compatible avec le dispositif de calcul, à savoir avec les circuits 8 de calcul de Transformée de Fourier rapide inverse utilisés. La sortie du circuit de calcul de Transformée de Fourier inverse (FFT⁻¹) 8 est connectée à un dispositif de sérialisation du signal 9. Le circuit de sérialisation 9 est connecté à un générateur du signal à émettre 10, lui-même connecté à un amplificateur 11 qui émet le signal par l'intermédiaire d'une antenne 12. Pour une description plus détaillée des différents circuits de l'émetteur on peut se référer à la demande de brevet WO-A-90 04893.

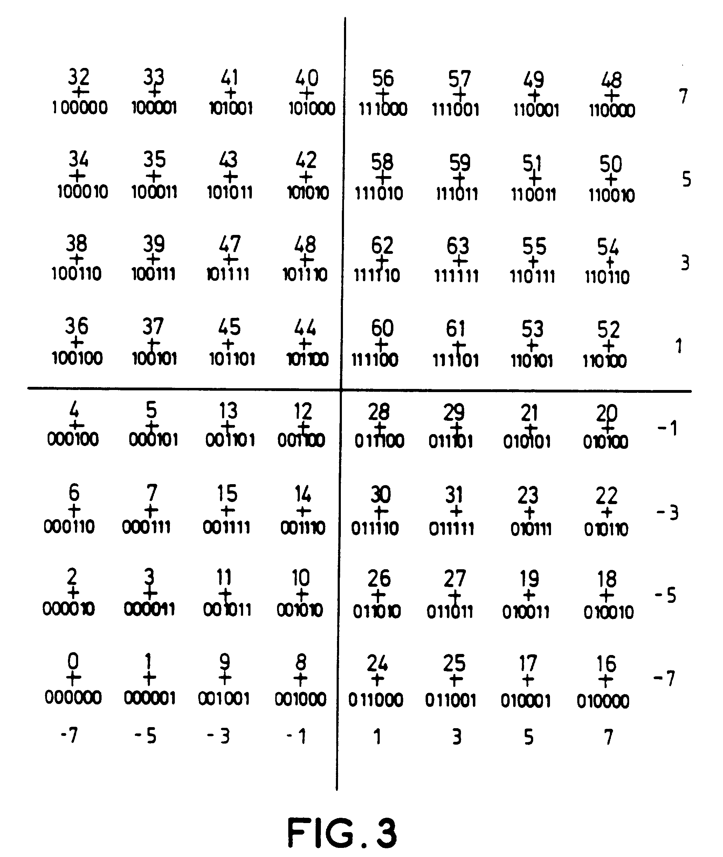

Comme mentionné ci-dessus, dans les mémoires du circuit de conversion 6 sont stockés les différents points d'une constellation permettant de transformer les mots numériques en entrée en des signaux complexes, à savoir donnant des couples amplitude/phase ou partie réelle/partie imaginaire en sortie. Ces constellations sont utilisées dans le cas d'une émission d'un signal numérisé modulé en utilisant une modulation multiporteuse de type OFDM (Orthogonal Frequency Division Multiplexing en langue anglaise). Pour éviter le maximum d'erreurs lors de la réception de l'onde modulée selon ce type de modulation, on propose conformément à la présente invention un codage particulier en binaire des N points de la constellation. Conformément à ce procédé de codage, deux points adjacents de la constellation correspondent à des mots binaires qui diffèrent l'un de l'autre d'au plus deux bits. Ce type de codage sera illustré en se référant aux figures 3 à 6 qui correspondent à quatre constellations différentes utilisant le même principe de codage.

Sur les figures 3 à 6, on a représenté une constellation carrée comportant 64 points. Toutefois, il est évident pour l'homme de l'art que la présente invention peut s'appliquer à d'autres types de constellations notamment des constellations dans lesquelles les points sont répartis sur des cercles concentriques ou sur des quadrilatères imbriqués tels que des carrés ou des rectangles. De plus, le nombre de points n'est pas limitatif. Il a été choisi de manière à simplifier la réalisation du matériel. En effet, le nombre de points composant une constellation a une incidence directe sur le débit de la liaison et est choisi en fonction du rapport signal à bruit et de la distorsion caractéristique de la liaison.

D'autre part, les mots numériques en entrée sont codés sur 6 bits, ce codage correspondant aux nombres de points de la constellation, à savoir 64. Ainsi, comme représenté sur la figure 1 et conformément à la présente invention, le mot binaire O codé en "000000" est placé au sommet du carré externe de la constellation. Les 63 autres points sont eux codés de la manière suivante : les mots horizontalement et verticalement adjacents correspondent à des mots binaires qui différent l'un de l'autre par un seul bit. Ainsi, sur la même ligne horizontale que le mot O a été placé le mot 1 correspondant au codage "000001" et sur la même ligne verticale que le mot O a été placé le mot 2 correspondant au codage "000010". De même, sur la même ligne horizontale, le mot 1 est suivi du mot 9 correspondant au codage "001001" tandis que sur la même ligne verticale, le mot 2 est suivi du mot 6 correspondant au codage "000110" et ainsi de suite comme représenté sur la figure 3.

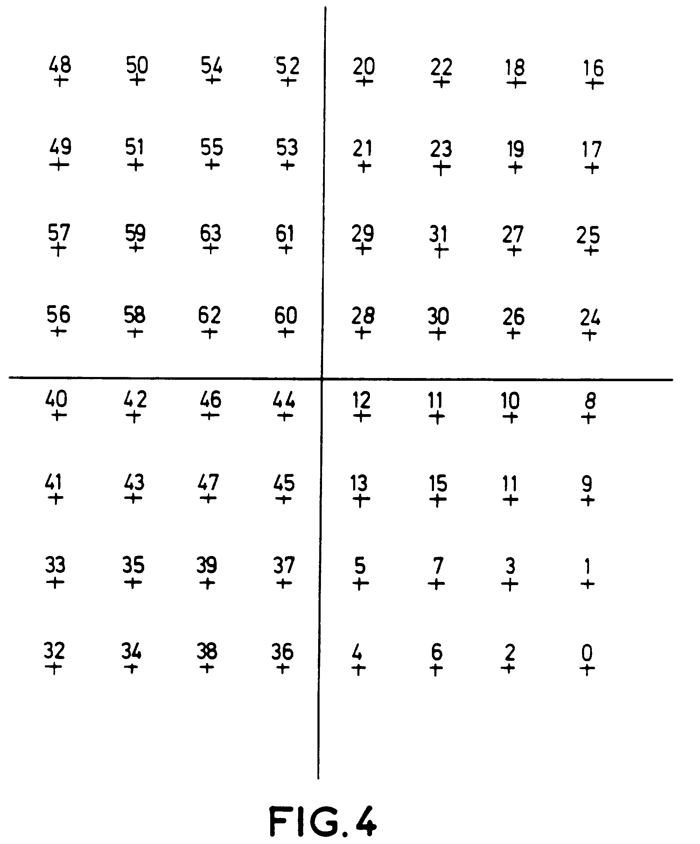

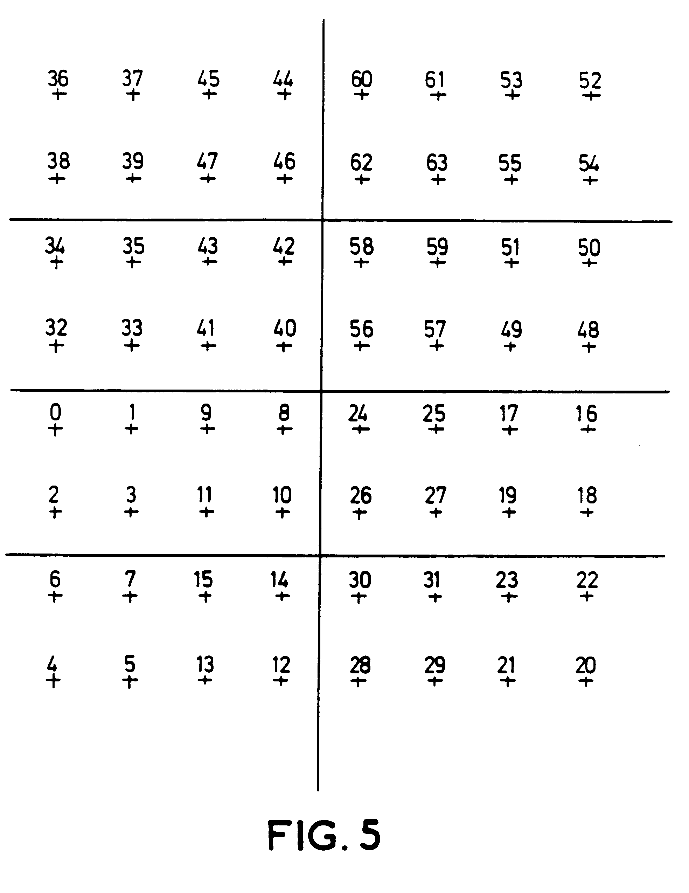

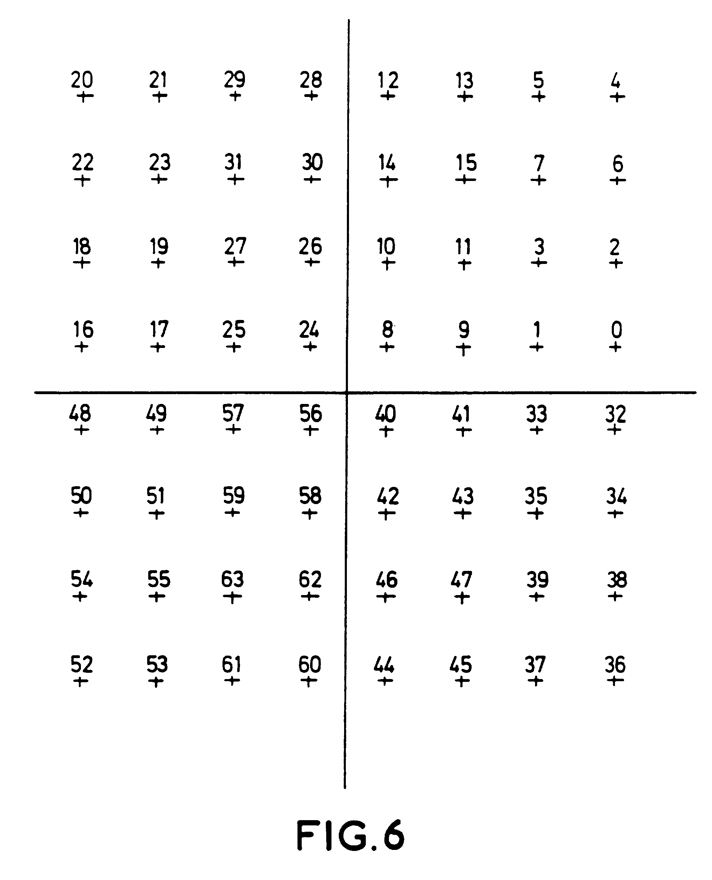

D'autre part, conformément à la présente invention, deux points de la constellation diagonalement adjacent correspondent à des mots binaires qui différent l'un de l'autre par deux bits. En conséquence, sur la diagonale le mot binaire 0 est suivi du mot 3 correspondant au codage "000011", lui-même suivi du mot 15 correspondant au codage "001111". En conséquence un type de codage correspondant à la présente invention est représenté sur la figure 3. D'autres types de codages correspondant aux mêmes critères peuvent être utilisés, notamment le codage représenté sur la figure 4 qui est issu du codage de la figure 3 par une rotation de 90° par rapport au centre de la constellation. De même, le codage de la figure 5 dans lequel le mot O n'est plus placé sur un sommet du carré externe mais près de la ligne centrale. Un autre type de codage est celui représenté sur la figure 6 qui se déduit de celui de la figure 5 par une rotation de 180°. En fait, différentes constellations peuvent être obtenues à partir de la constellation représentée sur la figure 3 par des transformations simples telles que des rotations ou des symétries.

La présente invention concerne en particulier un procédé d'affectation d'une constellation à un canal. En effet, dans le procédé d'émission d'un signal utilisant une onde modulée OFDM, on utilise un nombre important de canaux orthogonaux entre eux. La modulation est réalisée en affectant à chaque canal une amplitude et une phase tirées parmi les points d'une constellation en fonction des données à transmettre, puis on opère ensuite une Transformation de Fourier inverse sur le tableau de points générés à l'étape précédente. Pour éviter qu'une suite continue de "0" ou de "1" ne provoque une sommation en phase de porteuses d'amplitude maximale, il est nécessaire de pouvoir disposer les points des constellations de façon aléatoire d'un canal au suivant. En conséquence, conformément à la présente invention, on affecte à chaque canal, par tirage au sort parmi un nombre fini de constellations vérifiant les propriétés d'adjacence des points, une constellation de manière à éviter la sommation en phase des signaux. De ce fait, le transcodage du mot numérique en un point de la constellation devient une fonction connue à l'émetteur et au récepteur du numéro de canal. Pour réaliser ceci, on utilise plusieurs constellations. On peut par exemple utiliser huit constellations issues des constellations représentées sur les figures 3 à 6 et on affecte par tirage au sort au P canaux, à savoir par exemple au 512 canaux utilisés dans le mode de réalisation de la présente invention, une constellation parmi les huit constellations stockées dans la ou les mémoires du circuit de conversion 6, cette affectation étant réalisée une fois pour toute. Pour cela, on entre dans le circuit de conversion le numéro de canal codé sur 9 bits dans une mémoire 60 faisant correspondre au numéro de canal un numéro de constellation vers lequel seront envoyés les mots numériques en entrée codés sur 6 bits pour les transformer en un mot complexe I,Q dont chaque élément est codé sur 8 bits de manière connue. De ce fait, on utilise donc dans les dispositifs émetteur et récepteur pour la mise en oeuvre du procédé une table d'affectation déterminée une fois pour toute et sans laquelle on risque de saturer certains maillons de la chaîne de transmission.

Le contenu de la mémoire 60 pourra avantageusement être calculé à partir de tirages aléatoires selon une méthode de type Monté-Carlo.

## Revendications

1. Procédé de transmission d'un signal numérique constitué d'une succession de mots binaires comportant un codage par constellation (6) affectant à chaque mot binaire une amplitude et une phase et une modulation multiporteuse de type OFDM (Orthogonal Frequency Division Multiplexing) (8) par le signal numérique, chaque porteuse correspondant à un canal, caractérisé en ce que ladite modulation est réalisée en affectant à chaque canal une constellation parmi un nombre fini de constellations, cette affectation étant effectuée de manière aléatoire et réalisée une fois pour toutes.

2. Procédé selon la revendication 1, caractérisé en ce que deux points adjacents d'une constellation correspondent à des mots binaires qui diffèrent l'un de l'autre d'au plus deux bits.

3. Procédé selon les revendications 1 ou 2, caractérisé en ce que les points d'une constellation sont répartis sur des cercles concentriques ou des quadrilatères imbriqués.

4. Procédé selon l'une quelconque des revendications 2 ou 3, caractérisé en ce que deux points d'une constellation horizontalement et verticalement adjacents correspondent à des mots binaires qui diffèrent l'un de l'autre par un seul bit tandis que deux points de cette même constellation diagonalement adjacents correspondent à des mots binaires qui différent l'un de l'autre par deux bits.

## Patentansprüche

1. Verfahren zum Übertragen eines digitalen Signals aus einer Folge von binären Wörtern, enthaltend eine Kodierung durch eine Konstellation (6), die jedem binären Wort eine Amplitude und eine Phase und eine Mehrträgermodulation vom Typ OFDM (Orthogonal Frequency Division Multiplexing) (8) durch das digitale Signal zuordnet, wobei jeder Träger einem Kanal entspricht, dadurch gekennzeichnet, daß die Modulation dadurch erfolgt, indem jedem Kanal eine Konstellation unter einer begrenzenten Zahl von Konstellationen zugeordnet wird, wobei diese Zuordnung zufallsgesteuert erfolgt und einmal für alle durchgeführt wird.

2. Verfahren nach Anspruch 1, dadurch gekennzeichnet, daß zwei nebeneinanderliegende Punkte einer Konstellation binären Wörtern entsprechen, die sich voneinander um höchstens zwei Bits unterscheiden.

3. Verfahren nach Anspruch 1 oder 2, dadurch gekennzeichnet, daß die Konstellationspunkte auf konzentrische Kreise oder einander überlappende Vierecke verteilt sind.

4. Verfahren nach einem der Anspruch 2 oder 3, dadurch gekennzeichnet, daß zwei horizontal und vertikal nebeneinanderliegende Konstellationspunkte binären Wörtern entsprechen, die sich voneinander um ein einziges Bit unterscheiden, während zwei diagonal nebeneinander liegende Punkte derselben Konstellation binären Wörtern entsprechen, die sich voneinander durch zwei Bits unterscheiden.

## Claims

1. Method of transmitting a digital signal consisting of a succession of binary words comprising a constellation-based coding (6) which assigns each binary word an amplitude and a phase and a multicarrier modulation of OFDM type (Orthogonal Frequency Division Multiplexing) (8) by the digital signal, each carrier corresponding to a channel, characterized in that the said modulation is carried out by assigning each channel a constellation from a finite number of constellations, this assignment being performed in a random manner and carried out once only.

2. Process according to Claim 1, characterized in that two adjacent points of a constellation correspond to binary words which differ from one another by at most two bits.

3. Method according to Claims 1 or 2, characterised in that the points of a constellation are distributed over concentric circles or nested quadrilaterals.

4. Method according to either one of Claims 2 and 3, characterised in that two horizontally and vertically adjacent points of a constellation correspond to binary words which differ from one another by a single bit, whereas two diagonally adjacent points of this same constellation correspond to binary words which differ from one another by two bits.
